# EUROPEAN PATENT APPLICATION

(11) **EP 1 035 576 A2**
(43) Date of publication of application: **13.09.2000**
(21) Application number: 00104406.4
(22) Date of filing: 02.03.2000
(51) Int. Cl.: H01L 21/768, H01L 21/3105

(54) **A processing method of silicon epitaxial growth wafer and a processing apparatus thereof**

(30) Priority: 08.03.1999 JP 6037999
(71) Applicant: SpeedFam- IPEC Co., Ltd., Ayase-shi, Kanagawa-ken 252-1123 (JP); Super Silicon Crystal Research Institute Corp., Gumma 379-0125 (JP)
(72) Inventor: Yanagisawa, Michihiko, Ayase-city, Kanagawa-pref. 252-1123 (JP); Okawa, Shinji, Super Silicon Crystal Res. Inst.Cor, Annaka-city, Gunnma-pref. 379-0125 (JP); Abe, Kozo, Super Silicon Crystal Res. Inst. Corp., Annaka-city, Gunnma-pref. 379-0125 (JP)
(74) Representative: Albrecht, Thomas, Dr.

(57) **Abstract**

The present invention relates to provide a method for the preparation of silicon epitaxial growth wafer in which a planarization process by down stream type plasma etching and an epitaxial layer growing process are carried out by series, further relates to a silicon epitaxial growth wafer preparing apparatus comprising a vacuum room in which a plasma planarization chamber by plasma etching, an epitaxial layer growing chamber, a wafer aligning chamber, a wafer load lock chamber and a wafer transferring robot are contained.

## Description

The present invention relates to a preparation of very flat silicon wafer on which surface an epitaxial layer is grown, more in detail relates to a preparation method of an epitaxial growth wafer by a plasma etching method including a treating method of silicon wafer before epitaxial growing process, further relates to an apparatus thereof.

Electric parts such as IC, LSI, or VLSI, which are made from semiconductor materials e.g. silicon mono crystalline, are produced as follows. That is, an ingot of a silicon mono crystalline or other compound semiconductor is sliced to a thin wafer, precise electrical circuit pattern is formed on the surface of wafer and divided to small chips. At the processing of a silicon wafer or a compound semiconductor, which are the starting material of these electric parts, the surface of these wafers must be processed to have very precise surface roughness and dimensional stability. Especially, in recent years, along with the high integration of LSI device, an epitaxial growth wafer on which surface an epitaxial layer is grown is becoming the object of public interest. In a case of bulk wafer which is used as a material of an epitaxial growth wafer, since more accuracy precision is required compared with the wafer which is provided to the ordinary process, the improvement of silicon wafer processing technique is required more impatiently.

An as cut wafer prepared by slicing an ingot of silicon mono crystalline is lapped, etched and polished as to be processed to a mirror finished wafer at least whose one side is mirror finished, then, on said mirror finished surface an epitaxial layer is grown. The producing process of a silicon wafer which becomes a substrate of an epitaxial growth wafer is roughly illustrated as follows. That is, an as cut wafer sliced from an ingot of silicon mono crystalline is lapped or ground to obtain good dimensional accuracy, then the work damaged layer and stuck impurity debris on lapped wafer surface are removed by chemical etching process using chemicals such as alkaline solution. The etched surface is then polished and the mirror finished surface is obtained. The polishing process is composed of 3 or more steps, for example, the first, the second pre-polishing and the final polishing. The object of said polishing process, is the improvement of surface roughness and the removal of ripple, haze or micro roughness which are the factor of surface roughness. After that, the obtained polished wafer is washed so as to remove the fine particles of slurry (abrasive) or fine debris of polishing pad stuck on the surface, and packed into a wafer container in a clean chamber, and transferred to an epitaxial growing process.

Further, in recent years, as proposed in USP 5,336,355 or in Japanese Patent Laid Open Publication 9-246250, a method by plasma etching is used instead of a conventional polishing method to obtain an ultra precision flatness. In this case, after processed by first pre-polishing, the wafer is processed by a plasma etching method to obtain more precision flatness. However, in this case, it is difficult to remove defects such as haze or micro roughness which generate on the surface of wafer at the 1st pre-polishing by the plasma etching planarization. Further, by the method disclosed in USP 5,336,355, which generates plasma by parallel flat plate electrode closely to the wafer, the following problem can be mentioned. Namely ions generated in plasma are accelerated by a potential difference between electrode and plasma incident to the electrode, scatter the material of electrode and contaminate the surface of wafer, or incident to the surface of wafer and damage the surface. Therefore, it is necessary to polished the said processed surface by a conventional polishing method. It is well known that the plasma etching is a surface removing reaction by plasma reactive gas and carried out in dry condition. On the contrary, since the conventional polishing is carried out in wet condition, the processing of this case should be carried out by wet-dry-wet condition, and this point is pointed out as a big problem.

At the growing process of an epitaxial layer, the obtained mirror finished wafer as above is washed by mixed alkaline solution composed of ammonia and hydroxide peroxide and/or aqueous solution of fluoric acid, then transferred into epitaxial grow chamber. In this chamber, the wafer is heat treated by the temperature of 1150°C for 10 minutes in the atmosphere of hydrogen gas, and the carbon type impurity or natural oxidized film are removed. In a case of plasma planarized wafer, sometimes the work damaged layer whose crystal structure is distorted reminds more or less after the final polishing, which can be eliminated by heat treatment. Then, by treating with mixed gas composed of trichlorosilane gas and hydrogen gas at the temperature of 1070°C, the epitaxial layer can be grown. Furthermore, the epitaxial layer can be grown by CVD method which uses thermal decomposition reaction of SiH₄.

By the conventional method mentioned above, the polishing is carried out in wet condition, meanwhile, plasma etching is carried out in dry condition. Therefore, the wafer must be washed after polishing, dried up and preserved, and just before the epitaxial growing process said preserved wafer must be washed again. Thus, the process is very complicated and the washing processes are duplicated, and an inefficiency of the processes is pointed out as the problem.

One of the reasons of said problem can be illustrated as follows. That is, the wafer which is presently used in the field of electric device can be classified to a bulk wafer which is sliced, lapped and polished, SOI (silicon on Insulator) wafer which has triple structure of silicon mono crystalline-silicone oxidization film-silicon thin layer, an epitaxial growth wafer which grows an epitaxial layer on the surface of bulk wafer and others. Before said polishing and washing process, these wafers are processed by same way, and after washing a bulk wafer is inspected and shipped. In the meanwhile, after washing, SOI wafer and epitaxial growth wafer are transferred to a specific process respectively. As mentioned above, after washing, all wafers must be temporally preserved in a cassette type container. According to the requirement from the next process such as inspection, SOI wafer producing process or epitaxial growing process, necessary quantity of wafer are took out from the container, therefore, the approximate preserving period of wafer in the container is from several days to one month around.

Usually, since the shipping quantity of wafer for an epitaxial growth wafer process is very small compared with the shipping quantity for a bulk wafer process, above mentioned inefficient duplicated process is not recognized as a big problem. However, recently, along with the requirement of high integration of LSI device, the major improvement of silicon wafer crystalline quality is becoming necessary, and an epitaxial growth wafer is becoming more popular. Therefore, said inefficiency of the processes is becoming to be pointed out as a new and a big problem.

Further, as the second problem, the following problem is pointed out. Namely, since the conventional process for a mirror finished wafer which needs excellent precise flatness is not developed as to be used for the process of an epitaxial growth wafer, it includes a final finishing process which is not necessary for an epitaxial growth. And, even if in a case that a plasma planarization process is used, a final polishing process which is carried out in wet condition is needed as the final step. That is, a plasma planarization process is carried out in dry condition, meanwhile a final polishing process must be carried out in wet condition. That is, the coordination of processes is not so good, further an additional washing process becomes necessary after prepolishing process, which causes a cost up problem of wafer.

The inventors of this invention have carried out an intensive study to solve the problem which epitaxial growth wafer has, and has found that by continuously process a bulk wafer after prepolishing and washing, drying process in dry condition, the coordination of processes becomes good and high efficient processing can be carried out and a wafer of excellent quality can be obtained. The object of this invention is to provide a high efficient preparing method of silicon epitaxial growth wafer.

Above mentioned object is accomplished by a method for the preparation of silicone epitaxial growth wafer in which a planarization process by plasma etching and an epitaxial layer growing process are carried out by series. The planarization process by plasma etching used in this invention is desirably to be a down stream type etching method, further, gas which contains sulfur hexafluoride and hydrogen gas can be used as the desirable gas. And in said planarization process, it is desirable that the silicon wafer is heated to the temperature higher than 200°C and lower than 1200°C at the etching process.

Further, another object of this invention can be accomplished by a silicon epitaxial growth wafer preparing apparatus comprising a vacuum room in which a plasma planarization chamber by plasma etching, an epitaxial layer growing chamber, a wafer aligning chamber, a wafer load lock chamber and a wafer transferring robot are contained.
FIG.1 is a drawing showing one example of a wafer planarization apparatus using down stream type plasma etching method that construct the preparation method of an epitaxial growth wafer of this invention.
FIG.2 is a drawing showing one example of an epitaxial growing apparatus that construct the preparation method of an epitaxial growth wafer of this invention.
FIG.3 is a drawing showing one example of the arrangement of each process of the preparation method of a silicon wafer epitaxial growth wafer of this invention.
FIG.4 is a simplified flow chart of an epitaxial growth wafer preparation process of this invention and a conventional preparation process.

### Illustration of marks

1: silicon wafer, 2, 2' : stage, 3 : X axis driving motor,
4 : Y axis driving motor, 5 : nozzle, 6 : plasma generation zone,
7 : micro wave electric source, 8 : process gas supply line,
9 : XY axis scan control computer, 10 : gate valve, 11 : halogen lump,
12 : wafer transferring robot arm,
A : wafer aligning chamber,
B : wafer transferring chamber,
C : plasma planarization chamber,
D : epitaxial layer growing chamber,
E : sheet feeding type load lock chamber,
F : vacuum room,
G : wafer thickness distribution measuring apparatus

The important point of this invention is that a planarization process by plasma etching and an epitaxial layer growing process are carried out by series. That is, the wafer preparing processes from crystal pulling process to washing and drying process after prepolishing process are carried out by a conventional process, however, the all apparatuses used for the latter processes from prepolishing are contained in one vacuum room. Wafers to be processed are continuously fed to a container and transferred to each preparing process piece by piece. Among these processes, a wafer is not took out to the atmosphere. The transferring of wafer from process to process is carried out by a wafer transferring robot which is set up in said vacuum room.

Between said two processes, since wafer is not took out from the vacuum room and transferred directly from plasma etching process to hydrogen heat treatment furnace, wafer does not contact with oxygen, humid contained in atmosphere or contamination subject such as dust and can prevent the problems of impurity absorption or adhering of particles. As mentioned above, said two processes are carried out continuously by series, therefore wafers are not stocked between said two processes. That is, this invention is quite different from the conventional process which wafer are stocked between said two processes. Therefore, in this invention, a washing or a drying processes are not necessary between said two processes. Namely, by this invention, several processes can be omitted and consequently the improvement of yield of products can be expected.

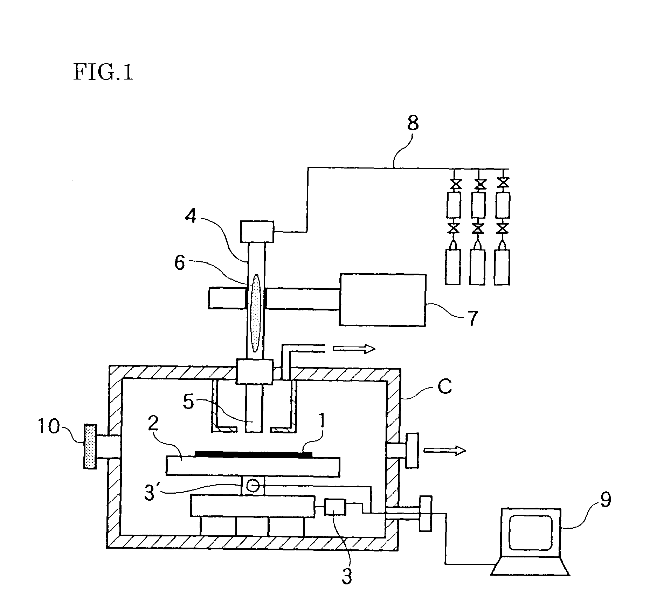

FIG.1 is a drawing of one concrete example of the planarization apparatus by plasma etching of this invention. The plasma etching process shown in FIG.1 is based on a down stream method characterizing the distance between a nozzle of plasma generating zone in a quartz reactor tube and silicon wafer is long. By this method, the metallic impurity generated from an electrode can be reduced, further the generated ions eliminate before reaching to the surface of wafer because the distance between said nozzle and wafer is long. Therefore, the damage of wafer by ion impact, that is, the distortion of crystal structure that is usually observed in a conventional plasma etching method can be avoided. Concretely, the depth of damage by conventional plasma etching is almost 1000Å, and this can be improved to substantially zero level. In conventional plasma etching method, it is necessary to remove said distorted layer by polishing in wet condition and by washing, mean while, by the method of this invention these mentioned processes can be omitted.

The polishing by plasma etching method of this invention is illustrated as follows. That is, a volatile molecule is formed by the reaction between reactive radical of specific atom which is plasma excited in a plasma generating tube and an atom in solid, and the surface of solid is removed by vaporizing of said formed volatile molecules, and in the present invention, it is intended to use said removing phenomenon to the polishing of the surface of silicon wafer. The important point of this invention is to use sulfur hexafluoride gas containing hydrogen gas as a material gas and to generate fluorine radical by exciting said material gas in a reactor tube, and to irradiate said fluorine radical to the surface of silicon wafer as to carry out a processing corresponding to a polishing process. Especially, in the present invention, a down stream method in which the distance between a nozzle of plasma generating zone and silicon wafer is concretely longer than 100mm is preferably used.

The fluorine radical generated in plasma reactor tube is irradiated locally to the surface of silicon wafer right under the nozzle and reacts with silicon atom of wafer surface and forms volatile silicon tetrafluoride molecular that removed to the outside. The removal rate from the surface of silicon is decided by the relative scanning speed of wafer to the nozzle, and when the scanning speed is high the removal rate becomes low, on the contrary when the scanning speed is slow the removal rate becomes high. The plasma planarization of this invention uses this phenomenon. By making the scanning speed of wafer slow at the peaked point of the wafer, by making the scanning speed of wafer fast at the sunken point of the wafer and by scanning whole surface of wafer by irradiation of fluorine radical, the planarization of wafer can be accomplished. Ions are generated simultaneously in the plasma reactive tube, however, in the present invention, since a down stream method in which the distance between a nozzle of plasma generating zone and silicon wafer is long is used, said generated ions are eliminated and do not arrive to the surface of wafer surface and do not distort the crystal structure of wafer.

The polishing of the whole surface of wafer can be accomplished by placing a wafer on a stage which can be scanned to the direction of X and Y axis and by processing the whole surface of wafer with scanning the wafer gradually. Before the scanning action of wafer to X or Y axis, whole surface profile of wafer is previously detected by a wafer thickness distribution measuring apparatus and the detected profile date is stocked in a control computer. At the operation of scanning to the direction of X and Y axis, the stocked profile date in said control computer is desirable to be fed back to the XY driving motors attached to the stage and control the scanning speed of wafer by scanning the stage according to the stocked profile date of the wafer. As the reacting tube for plasma generation, for example, a tube made from quartz, aluminum or sapphire can be used.

As mentioned above, by using sulfur hexafluoride gas containing hydrogen gas as the plasma gas, a partial hydrogen heat treatment is carried out. Said partial hydrogen heat treatment is based on the heat of reaction generated at etching reaction. By this heat treatment, the necessary time for the subsequent heat treatment can be remarkably reduced. And, if the wafer is heated at this point, said effect can be further accelerated. Concerning the means to heat the wafer is not restricted, and the desirable temperature of heated wafer is from 200°C to 1200°C. When the temperature of wafer is lower than 200°C, the influence to the subsequent heat treatment time is too small. And when the temperature of wafer is higher than 1200°C said temperature is very closed to the substantial heat treatment temperature of 1150°C and is in danger of exceeding said temperature.

The planarized wafer by plasma etching process is heated to 1150°C under hydrogen gas atmospheric condition to carry out the previous heat treatment. By the previous heat treatment, impurity and oxidation layer of wafer are removed and distorted crystal structure is also eliminated. Then the wafer is heated to 1070°C in the atmosphere of mixed gas composed of trichlorosilane and hydrogen gas and the epitaxial thin layer is formed on the surface of wafer. Trichlorosilane is reduced by hydrogen gas and a silicon epitaxial thin layer is formed on the surface of wafer. The heating means of wafer is not restricted, however, it is desirable to use a halogen lump because the up and down of temperature at short period is required.

The present invention will be illustrated more minutely with reference to the drawings, however, not intended to limit the scope of invention. FIG.1 is one Example of planarization apparatus of this invention, which uses a down stream type plasma etching method. A silicon wafer 1 is placed on a stage 2 which can be scanned to both direction of X and Y axis, and said stage 2 is contained in plasma planarization chamber C. At the upper position of silicon wafer 1, a nozzle 5 of quartz discharge tube for plasma generation 4 is set up. The stage 2 can be driven to the direction of X and Y axis by the motion of X axis driving motor 3 and Y axis driving motor 3', and the silicon wafer 1 can be scanned to X axis and Y axis. The scanning of the stage 2 is controlled by the XY driving control computer 9 which is set up at the outside of the apparatus. The nozzle 5 of quartz discharge tube for plasma generation 4 is contained in the plasma planarization chamber C. And another end of the quartz discharge tube is connected to the process gas supply line 8 and at the plasma generating zone 6 of the quartz discharge tube a micro wave electric source 7 is set up.

By driving a vacuum pump (not shown in the drawing) connected to the plasma planarization chamber C, sulfur hexafluoride gas containing hydrogen gas which is a process gas is introduced through the process gas supply line 8 then the fluorine radical generated in the quartz discharge tube 4 by a plasma generating reactor and the generated fluorine radical is irradiated from the nozzle 5. Silicon wafer 1 is scanned by the X axis driving motor 3 and Y axis driving motor 3' attached to the stage 2 and is etched by the irradiated fluorine radical from the nozzle 5 of said quartz discharge tube 4. The fluorine radical locally attack the right under part of silicon wafer, while the silicon wafer is scanned to the direction of X and Y axis as mentioned above so as to process the whole surface of it. By making the distance between nozzle 5 of plasma generating zone 6 and silicon wafer 1 longer than 100mm, the generated ions in discharge tube are eliminated and not arrive to the surface of wafer. The obtained planarized wafer as above is transferred to the next epitaxial layer growing process, thus said two processes are carried out in series, and a washing and a drying processes are not needed between said two processes.

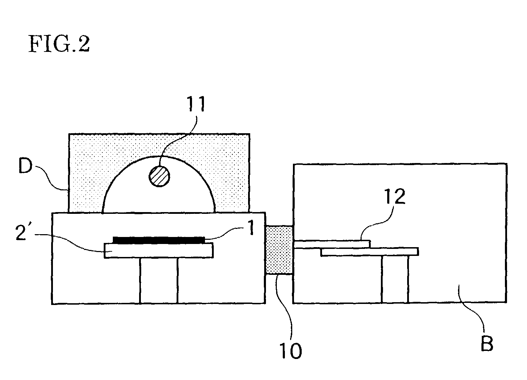

FIG.2 is one Example showing a preparation apparatus of silicon wafer epitaxial growing wafer. An epitaxial layer growing chamber D can be cut off by a gate valve 10, therefore the inside of it can be independently maintained at high vacuum condition by a vacuum pump (not shown in the drawing). Further, from another line (not shown in the drawing) trichlorosilane gas and hydrogen gas can be introduced into said chamber. A halogen lamp 11 installed at the upper part of the chamber can heat the wafer to the higher temperature. The planarised silicon wafer is placed on a stage 2', and in this chamber the previous heat treatment and the growth of silicon epitaxial layer are carried out.

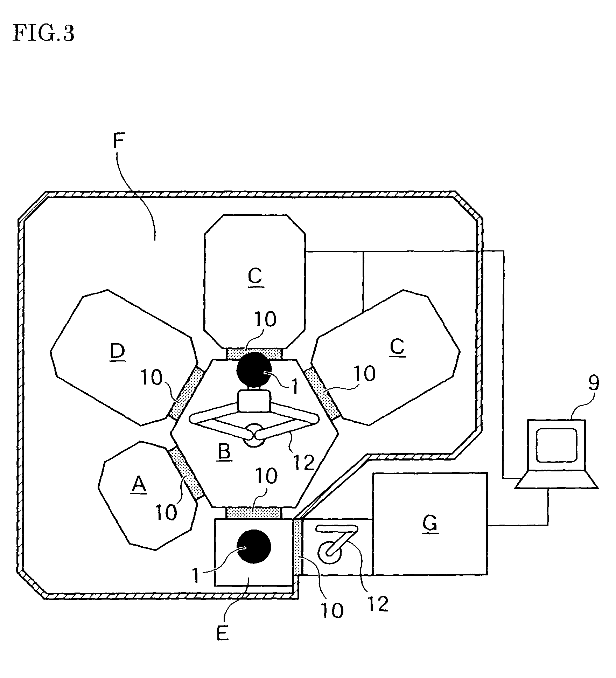

FIG.3 is one Example of the silicon wafer epitaxial growth wafer of this invention showing the arrangement of each process. In the Example shown in this drawing, a wafer planarization process by plasma and an epitaxial growing process is contained in one vacuum room and said two processes are carried out by series. In the center of the vacuum room F, a wafer transferring robot chamber B is set up and a wafer aligning chamber A, a plasma planarization chamber C by plasma etching method, an epitaxial layer growing chamber D and a sheet feeding type load lock chamber E are contained as to surround said wafer transferring chamber B, and connected respectively with chamber B setting up a gate valve 10 between. Each above mentioned chambers are connected with a vacuum pump independently, further gas supply line is connected to each chambers at need, and can be controlled independently. And a wafer thickness variation measuring apparatus G is placed at outside of the vacuum room.

TTV (total thickness variation) and profile of a prepolished wafer is measured by the wafer thickness variation measuring apparatus G and the wafer is transferred into the wafer aligning chamber A through sheet feeding type load lock chamber E. At the wafer aligning chamber A, the position of orientation flat of wafer is adjusted. Then the arm 12 of the wafer transferring robot chamber B transfers the wafer to the plasma planarization chamber C and the plasma planarization process is carried out on the wafer. The scanning speed of the wafer at the planarization is controlled by the control computer 9 based on the profile date measured by the wafer thickness variation measuring apparatus G, therefore very precise flatness can be obtained. Inside of the epitaxial growing chamber D is vacuumed to 10⁻⁶ Torr around before the wafer is inserted. When the vacuous level reaches to the desired level, the gate valve 10 is opened and the wafer after plasma planarization process is set on the stage 2' in the epitaxial growing chamber D. Then the gate valve 10 is closed and hydrogen gas is supplied into the chamber D. When inside pressure of the chamber D becomes atmospheric pressure a halogen lamp 11 installed at the upper part of the chamber D is turned on and the wafer is heated to the temperature of 1150°C to carry out the previous heat treatment. Then the supply of hydrogen gas is stopped and inside of chamber D is vacuumed again to 10⁻⁶ Torr around. After that the mixed gas of trichlorosilane and hydrogen gas is supplied to the chamber D, then when inside pressure of the chamber D becomes atmospheric pressure a halogen lamp 11 installed at the upper part of the chamber D is turned on again and the wafer is heated to the temperature of 1070°C so as to form an epitaxial layer. The supply of gas is stopped and inside of chamber D is vacuumed again to 10⁻⁶ Torr around, then the gate valve 10 is opened and the obtained epitaxial growth wafer is stored in a load lock chamber E through wafer transferring robot chamber B.

As mentioned above, the purpose of heat treatment before epitaxial growing process in the chamber D is to remove impurities or an oxidation film and to eliminate the distorted crystal structure layer, however, in a case of this invention, after plasma planarization process since a wafer is transferred to the epitaxial growing chamber D by series without took out from the vacuum room F, there is no opportunity for sticking of impurities and for forming of an oxidation film. Further, in this invention, since a down stream type of plasma etching method is used, the distortion of crystal structure scarcely occurs. Therefore, compared with a conventional method, the remarkable reduction of operation time at this process becomes possible. Furthermore, after the wafer on which an epitaxial layer is grown is took out, the epitaxial growing chamber D is already vacuumed to the desired vacuous pressure, therefore the next wafer to be processed can be transferred into the chamber D continuously. Thus, the remarkable reduction of operation time can be possible at this process too.

### EXAMPLE

The Example of the preparation of an epitaxial growth wafer by above mentioned silicon wafer epitaxial growth wafer processing apparatus will be illustrated more minutely, however, not intended to limit the scope of the invention.

### Example

TTV (Total Thickness Variation) of 25 pieces of 8 inches diameter mirror finished wafer specimens, which are processed by a conventional slicing, lapping, etching and polishing process, are measured by Ultra Gauge 9700 (product of ADE Co., Ltd.). After the measurement, specimens are fed to the sheet feeding type load lock chamber E shown in FIG.2 sheet by sheet and processed by a plasma planarization process. The plasma planarized wafers are took out and TTV after plasma planarization are measured. The average TTV of wafers before plasma planarization is 1.353µm, and the average TTV after plasma planarization is improved to 0.233µm.

Specimens of mirror finished wafer are processed according to the above mentioned processes by series and an epitaxial layer is grown on each specimen. The surface quality and crystal structure of each specimen are inspected. Results are summarized in Table 1. As clearly understood from the results, very good epitaxial layer can be grown without washing or other process after plasma planarization process.

**Table 1**

| items | method | results |
|---|---|---|
| hase | condenser lump (100000 lx) | no |
| defect | inspected by condenser lump after Secco etching | no |
| slip | inspected by naked eye | no |
| transition | inspected by optical microscope after Secco etching | no |
| surface roughness Ra | AFM | average 0.08nm same to before processing |

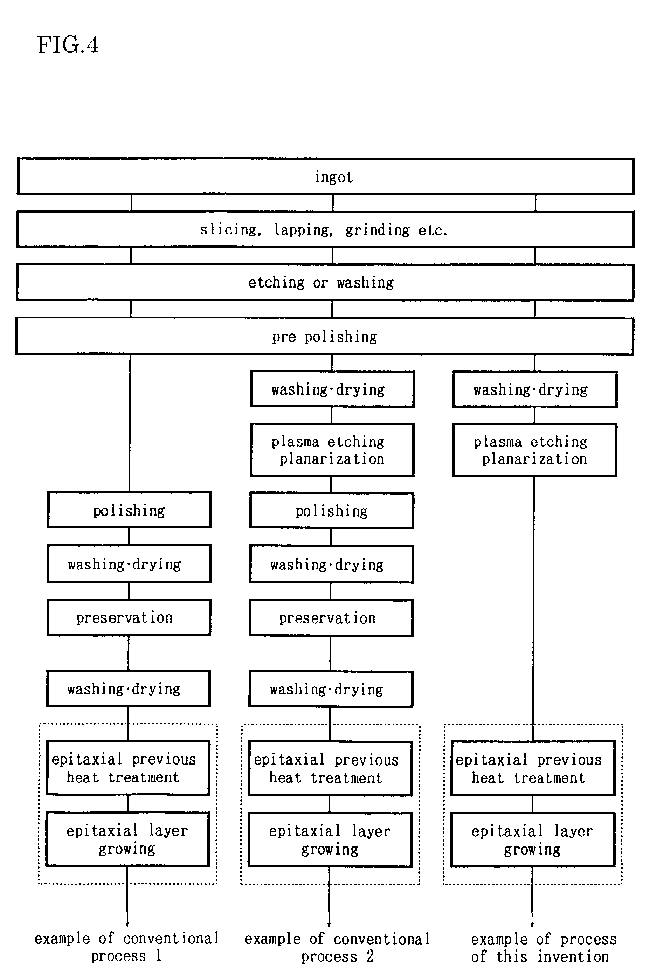

FIG.4 is a simplified flow chart of an epitaxial growth wafer preparation process of this invention in comparison with a conventional preparation process, in which a difference between said two processes is briefly illustrated. As clearly understood from this flow chart, the process by the present invention can remarkably omit accompanying processes. Further, in a case of this invention, since all processes after planarization process by plasma etching are carried out in dry condition and all apparatuses are contained in one big room, all processes can be carried out in series and totally the reduction of operation time is about 25%.

### Effect of the Invention

As mentioned above, by using the preparation method and apparatus for epitaxial growth wafer of this invention the problems which conventional method has can be solved. Namely in the conventional method, a planarization process is carried out in wet condition, on the contrary, an epitaxial layer growing process is carried out in dry condition and the coordination of said two processes is very bad, further, a washing and a drying processes are needed between said two processes. Therefore, the problem of productive effect and the problem from the economical view point are pointed out. By the present invention, since a planarization is carried out by plasma etching method in dry condition by series without taking idle time between two processes, the accompanying processes can be remarkably omitted, further the operation time necessary for previous heat treatment before epitxial process can be remarkably reduced.

## Claims

1. A method for the preparation of silicone epitaxial growth wafer in which a planarization process by plasma etching and an epitaxial layer growing process are carried out by series.

2. The method for the preparation of silicon epitaxial growth wafer of claim 1, wherein the planarization process by plasma etching is a down stream type plasma etching.

3. The method for the preparation of silicon epitaxial growth wafer of claim 1, wherein the gas used in plasma etching process contains sulfur hexafluoride and hydrogen gas.

4. The method for the preparation of silicon epitaxial growth wafer of claim 1, wherein silicon wafer is heated to the temperature higher than 200°C and lower than 1200°C at the etching process.

5. A silicon epitaxial growth wafer preparing apparatus comprising a vacuum room in which a plasma planarization chamber by plasma etching, an epitaxial layer growing chamber, a wafer aligning chamber, a wafer load lock chamber and a wafer transferring robot are contained.
